# EUROPEAN PATENT APPLICATION

(11) **EP 4 814 519 A1**
(43) Date of publication of application: **30.09.2026**
(21) Application number: 26161455.6
(22) Date of filing: 27.02.2026
(51) Int. Cl.: G01R 33/26, G01N 24/00

(54) **ATOMIC ELECTROMAGNETICALLY INDUCED TRANSPARENCY MAGNETOMETER UTILIZING INTEGRATED PHOTONICS**

(30) Priority: 24.03.2025 US 202563776840 P; 07.10.2025 US 202519351777
(71) Applicant: Honeywell International Inc., Charlotte, NC 28202 (US)
(72) Inventor: FERTIG, Chad, Charlotte, 28202 (US); DELLIS, Argyrios, Charlotte, 28202 (US); HORSTMAN, Luke, Charlotte, 28202 (US); PUCKETT, Matthew Wade, Charlotte, 28202 (US)
(74) Representative: Haseltine Lake Kempner LLP

(57) **Abstract**

An atomic magnetometer system comprises a physics package including a vapor cell; a first PLC chip coupled a first side of the cell and projecting a first beam triad through the cell; and a second PLC chip coupled to a second side of the cell and projecting a second beam triad through the cell. A first set of photodetectors receives the first beam triad, and a second set of photodetectors receives the second beam triad. A laser source optically communicates with PLC chips and emits a laser beam, which is split into a first beam portion directed to the first PLC chip, and a second beam portion directed to the second PLC chip. The first beam triad is produced from the first beam portion, and the second beam triad is produced from the second beam portion. A processor performs EIT magnetometry based on output signals from the photodetectors.

## Description

### CROSS REFERENCE TO RELATED APPLICATION

This application claims the benefit of and priority to U.S. Provisional Application No. 63/776,840, filed on March 24, 2025, the disclosure of which is herein incorporated by reference.

### BACKGROUND

Atomic magnetometry, which senses the magnitude and direction of magnetic fields by measuring their effect on quantum coherences in atoms, offers a combination of best-in-class sensitivity and long-term stability. Given the host of applications that could benefit from such advanced sensing capabilities, such as magnetic anomaly navigation and stand-off detection capabilities, it is unfortunate that the current generation of quantum magnetometers do not enjoy widespread deployment due to their vulnerability to electromagnetic interference (EMI), vibrations, and large stray magnetic fields typical of some platforms.

### SUMMARY

An atomic magnetometer system comprises a physics package including a vapor cell having a first side and an opposing second side; a first planar lightwave circuit (PLC) photonic chip coupled to the first side of the vapor cell, the first PLC photonic chip configured to project a first triad of laser beams through the vapor cell; and a second PLC photonic chip coupled to the second side of the vapor cell, the second PLC photonic chip configured to project a second triad of laser beams through the vapor cell. A first set of photodetectors is configured to receive the first triad of laser beams that pass through the vapor cell; and a second set of photodetectors is configured to receive the second triad of laser beams that pass through the vapor cell. At least one laser source is in optical communication with the first and second PLC photonic chips, the at least one laser source including a laser device configured to emit a laser beam, which is split into a first beam emission portion that is directed to the first PLC photonic chip, and a second beam emission portion that is directed to the second PLC photonic chip. At least one processor is in operative communication with the physics package and the at least one laser source. The first triad of laser beams projected by the first PLC photonic chip is produced from the first beam emission portion, and the second triad of laser beams projected by the second PLC photonic chip is produced from the second beam emission portion. The at least one processor is configured to perform electromagnetically induced transparency (EIT) magnetometry based on output signals from the first and second sets of photodetectors.

### BRIEF DESCRIPTION OF THE DRAWINGS

Features of the present invention will become apparent to those skilled in the art from the following description with reference to the drawings. Understanding that the drawings depict only typical embodiments and are not therefore to be considered limiting in scope, the invention will be described with additional specificity and detail through the use of the accompanying drawings, in which:
Figure 1 is a perspective view of an atomic vector magnetometer that utilizes integrated photonics, according to one embodiment;
Figure 2 is a perspective view of an atomic electromagnetically induced transparency (EIT) magnetometer system that can implement the atomic vector magnetometer of Figure 1;
Figure 3 schematically illustrates an exemplary vector EIT magnetometer system that utilizes a single modulated laser beam;
Figure 4A schematically illustrates an example of vector EIT magnetometry according to one implementation;
Figure 4B schematically illustrates a local coordinate system for each probe beam used in the vector EIT magnetometry of Figure 4A;
Figures 5A and 5B are graphs of experimental data showing how an EIT transmission changes with respect to polarization angles;
Figure 6A is a schematic diagram of an atomic EIT magnetometer system, according to another embodiment; and
Figure 6B is a perspective view of the atomic EIT magnetometer system of Figure 6A.

### DETAILED DESCRIPTION

In the following detailed description, embodiments are described in sufficient detail to enable those skilled in the art to practice the invention. It is to be understood that other embodiments may be utilized without departing from the scope of the invention. The following detailed description is, therefore, not to be taken in a limiting sense.

Embodiments of an atomic electromagnetically induced transparency (EIT) magnetometer, utilizing integrated photonics, is described herein. In one embodiment, the present EIT magnetometer can be implemented as a dual-triad intelligent atomic differencing EIT magnetometer. The EIT magnetometer can be used in alternative navigation systems such as those based on magnetic anomaly navigation.

In general, the EIT magnetometer can be implemented in a physics package comprising a vapor cell, planar lightwave circuit (PLC) photonic chips, photodetectors, and gradient cancelling coils. The physics package can be constructed as a cemented assembly. The PLC photonic chips provide waveguide arrangements for splitting, routing, and projecting dual orthogonal triads of collimated laser beams. At least one processor is in operative communication with the physics package and is configured to perform EIT magnetometry based on output signals from the photodetectors.

The present EIT magnetometer can be implemented in a robust, atomic vector magnetometer system that is capable of detecting ultra-weak magnetic fields, even in harsh environments such as a helicopter platform. This atomic magnetometer system utilizes vector electromagnetically induced transparency (v-EIT ), which is uniquely suited as the core physics of the system because it can directly measure the complete B-field vector with a sensitivity of less than about 100 fT/Hz^{1/2} in magnetic fields of about 1 mT or greater.

The present magnetometer system processes EIT spectra collected simultaneously from two orthogonal laser beam triads probing a single miniature (e.g., about 5 mm) vapor cell. The laser beam triads can be generated from a pair of thin, rigid, PLC photonic chips, utilizing no free space optics (i.e., lenses, mirrors, etc.), optically cemented directly to the vapor cell for robustness against mechanical shocks and vibrations. The PLC photonic chips can be fabricated from a silicon nitride platform. In another embodiment, the present magnetometer system can be implemented to provide single shot, dead-zone free, true vector magnetometry with outstanding sensitivity through one or more artificial intelligence or machine learning (AI/ML) algorithms, which can be trained to process the EIT spectra data collected simultaneously from the two orthogonal laser beam triads probing the vapor cell.

The dual-triad probe beam configuration used in the present magnetometer system can be further exploited to achieve immunity to magnetic gradients of about 10 mT/m or greater. The AI/ML powered algorithms can extract B-field gradients from the EIT measurements taken from complementary beams of opposing beam triads. The magnetometer system then generates real-time cancelling gradients using ultra-low-noise current sources driving a set of gradient cancellation coils to actively flatten the gradients across the vapor cell, preserving the narrow EIT linewidths that enable the magnetometer system to reach its sensitivity limit (e.g., better than about 100 fT/rtHz). In one embodiment the cancellation coils are biplanar coils.

Further details of various embodiments are described hereafter and with reference to the drawings.

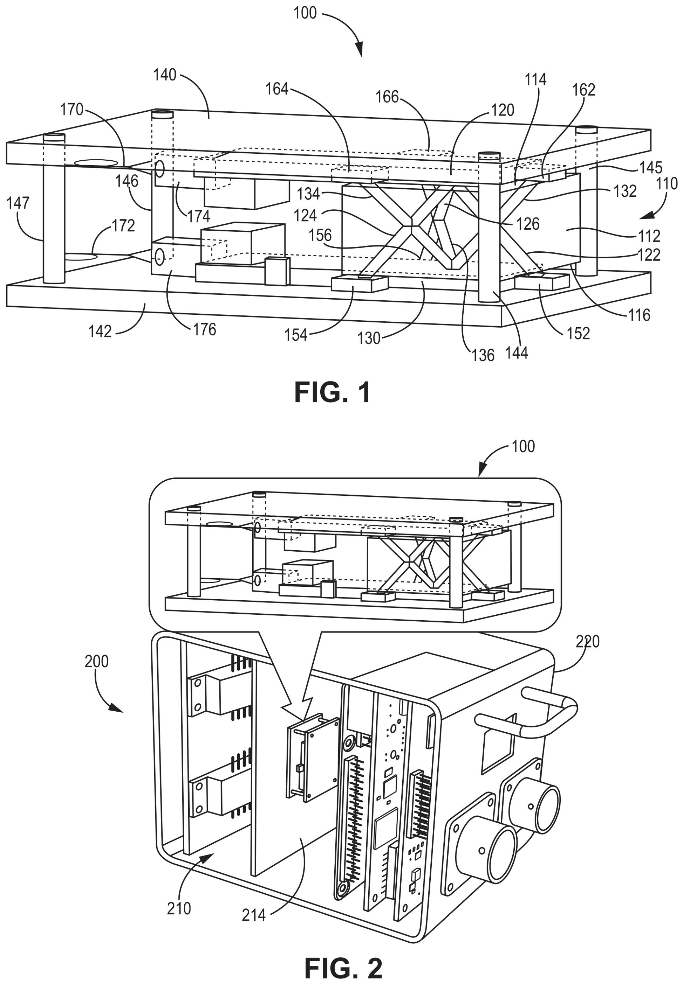

Figure 1 illustrates an atomic vector magnetometer 100 that utilizes integrated photonics, according to one embodiment. The atomic vector magnetometer 100 comprises a physics package 110 that includes a vapor cell 112 such as a rubidium vapor cell, which has a first side 114 and an opposing second side 116. A first planar lightwave circuit (PLC) photonic chip 120 is coupled to the first side 114 of the vapor cell 112. The first PLC photonic chip 120 is configured to direct a first triad of laser beams 122, 124, 126 through the vapor cell 112. A second PLC photonic chip 130 is coupled to the second side 116 of the vapor cell 112. The second PLC photonic chip 130 is configured to direct a second triad of laser beams 132, 134, 136 through the vapor cell 112.

The first PLC photonic chip 120 is attached to a first printed circuit board (PCB) 140, and the second PLC photonic chip 130 is attached to a second PCB 142. The first PCB 140 and the second PCB 142 are coupled together and separated from each other by a set of posts 144, 145, 146, 147. A first set of photodetectors 152, 154, 156 are attached to the second PCB 142, and are configured to respectively receive the first triad of laser beams 122, 124, 126 that pass through the vapor cell 112. A second set of photodetectors 162, 164, 166 are attached to the first PCB 140, and are configured to respectively receive the second triad of laser beams 132, 134, 136 that pass through the vapor cell 112.

As described in further detail hereafter, a laser source is in optical communication with the first and second PLC photonic chips 120, 130. The laser source includes a laser device configured to emit a laser beam, which is split into first and second beam emission portions that are respectively directed to the first and second PLC photonic chips 120, 130 through respective first and second optical fibers 170, 172. The optical fibers 170, 172 are respectively edge coupled to the first and second PLC photonic chips 120, 130 through respective first and second fiber-to-edge couplers 174, 176. In another embodiment, two different laser sources can be used, one in optical communication with the first PLC photonic chip and the other in communication with the second photonic PLC photonic chip.

In some embodiments, the first and second PLC photonic chips 120, 130 can include routing waveguide arrangements and grating emitters in optical communication with the routing waveguide arrangements. The routing waveguide arrangements direct the beam emission portions to the grating emitters, which are configured to produce the dual triad of laser beams from beam emission portions.

Figure 2 illustrates an atomic EIT magnetometer system 200 according to one embodiment. The magnetometer system 200 can be implemented with a set of functional cards 210 that are housed in a robust portable chassis 220, such as a VPX-style chassis. The functional cards 210 can include a digital card for processing components, a laser card for laser components, a low-noise card, and the like. In addition, one of the functional cards 210 includes a physics package card 214 that houses a physics package comprising an atomic vector magnetometer, such as the atomic vector magnetometer 100 of Figure 1.

In general, the laser card generates stabilized, modulated laser light and sends the laser light to the physics package card 214 via optical fibers. The low-noise card houses current supplies for the gradient cancelling coils, as well as photodiode/photodetector lock-in amplifiers. The digital card houses a main microprocessor, a field programmable gate array (FPGA), and a communication interface.

In other embodiments, an atomic vector magnetometer can be constructed with a physics package 110 that includes a vapor cell and a single PLC photonic chip, which produces a single triad of laser beams that are projected through the vapor cell.

Further details regarding the present atomic EIT magnetometer system and methods for operation thereof are described hereafter.

### Vector Electromagnetically Induced Transparency Magnetometry

The technique of v-EIT magnetometry is based on the interaction of two laser beam fields with a vapor of alkali atoms, forming a family of three-level A-type coherences. When the energy difference between the two laser fields is close to the energy separation between two ground state sublevels, a "dark" state is formed such that atoms no longer absorb the laser beams. A magnetic field piercing the vapor cell shifts the atomic levels and disturbs the dark states in a predictable pattern, and according to the relative orientation of the B-field to the laser polarization. The v-EIT exploits this effect to reconstruct the magnetic field through an analysis of the relative strength, widths, and frequency shifts of the narrow (e.g., ~kHz) spectral transmission peaks, resulting in an extremely sensitive and accurate measurement of the total vector magnetic field.

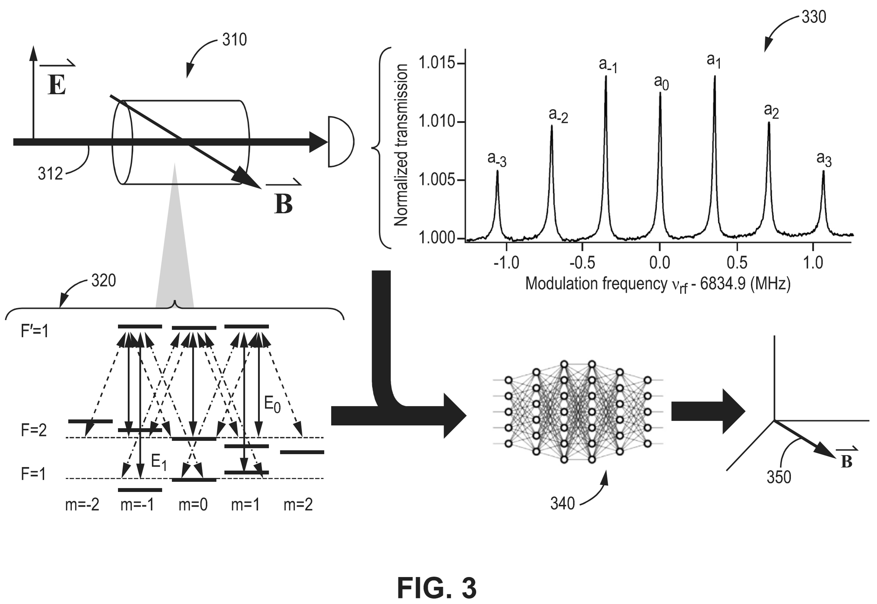

Figure 3 schematically illustrates an exemplary v-EIT magnetometer system 310 that utilizes a single modulated laser beam 312. A level structure is indicated at 320 for 87Rb in a vapor cell and coherences produced by the laser beam 312. The EIT transmission peaks are indicated at 330, with each peak separated in energy by *µ_{B}gB.* An AI/ML algorithm indicated at 340 is configured for extracting a total B vector 350 from the atomic spectra. The v-EIT magnetometer system 310 can operate in strong magnetic fields while maintaining exceptional magnetic sensitivity. The v-EIT magnetometer system 310 can employ linearly polarized, phase-modulated lasers in a configuration that strongly rejects laser technical noise such as relative intensity noise (RIN), frequency jitter, and polarization fluctuations.

A v-EIT magnetometer is capable of vector magnetometry in high fields with sensitivities of less than about 100 fT/Hz^{1/2} or better. In addition to its low fundamental noise limit, the v-EIT magnetometer has various advantages over other approaches to quantum magnetometry for harsh, dynamic sensing environments. In particular, these advantages include: v-EIT operates natively in high-fields with no degradation in sensitivity because v-EIT collects spectra from the entire manifold of EIT resonances, which are frequency split in direct proportion to the total magnetic field (ΔE ≈ µB · g ·B) for any magnitude field; and v-EIT produces true three-dimensional (3D) vector magnetometry by measuring and correlating the amplitudes of all EIT resonances to reconstruct the total B-field in magnitude and direction. In addition, v-EIT is immune to buffer gas collision shifts when using an isotropic buffer gas; and v-EIT is immune to quadratic Zeeman shifts, which are rejected in common mode by the spectral line differencing data reduction algorithm. Also, v-EIT is immune to atom-atom interactions, including spin-exchange, making it possible to use miniature micro-electro-mechanical systems (MEMS) scale vapor cells operated at elevated temperatures to achieve high atom densities and enhanced signal-to-noise ratio (SNR), without introducing noise or biases.

Further details regarding v-EIT magnetometry can be found in Maldonado et al., Sensitivity of a vector atomic magnetometer based on electromagnetically induced transparency, Opt. Express, vol. 32, no. 14, p. 25062, July 2024, the disclosure of which is incorporated by reference herein; and in Yudin et al., Vector magnetometry based on electromagnetically induced transparency in linearly polarized light, Phys. Rev. A, vol. 82, no. 3, p. 033807, Sept. 2010, the disclosure of which is incorporated by reference herein

### Dead-Zone-Free, Single-Shot Vector Magnetometry

By conducting v-EIT spectroscopy with an orthogonal [111] triad of independent beams of appropriately chosen polarizations, the full 3D magnetic field vector can be reconstructed with no angular dead-zones and in a single-shot, for example, without requiring repeated measurements as different pairs of Helmholtz coils are energized along each of three axes in sequence. Figure 3 described above illustrates how the amplitude of v-EIT resonances change as a fixed magnitude B field is rotated relative to one probe laser beam. The position and orientation of all the laser beams in a triad is established by the lithography of the photonic circuit from which they are emitted, making it highly insensitive to temperature variations and immune to disturbance by shock/vibration.

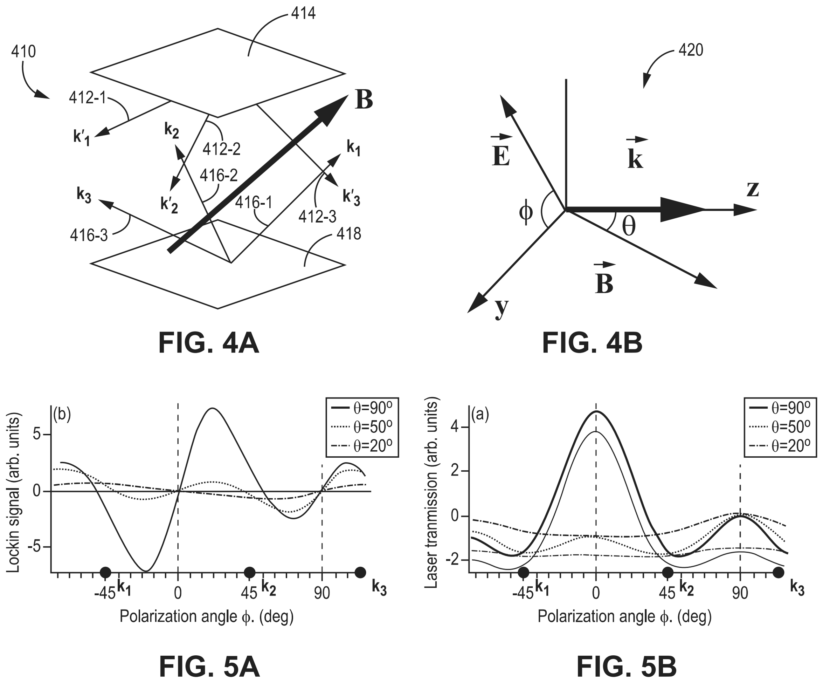

Figure 4A schematically illustrates an example of vector EIT magnetometry according to the present approach. As indicated at 410 dual orthogonal triads of laser beams are produced, with each triad of beams being emitted from a single planar lightwave circuit (PLC). In particular, a first set of triad probe beams 412-1, 412-2, 412-3 are emitted from a top PLC 414, and a second set of triad probe beams 416-1, 416-2, 416-3 are emitted from a bottom PLC 418. Figure 4B schematically illustrates a local coordinate system 420 for each probe beam of Figure 4A, where *̅k̅*̅ is the wave vector and *̅E̅*̅ the polarization; ***̅B̅*̅** is the magnetic field at a given point in the beam path.

Figures 5A and 5B are graphs of experimental data showing how the EIT transmission changes with respect to polarization angles (φ,θ). The triad probe beams provide measurements that uniquely constrain the B-field direction without requiring the sweeping of any parameter - hence "single-shot". Also, there is no B-field direction in which the measurement is singular - hence "dead-zone-free".

### Dual Orthogonal Triad Probes for Immunity to Large Gradients

In the present approach, while one orthogonal triad of probe beams can be used for the vector magnetometry protocol described in the previous section, using a second triad of probe beams provides beneficial redundancy. The primary role of the two triads of probe beams is to provide for a unique high dynamic range, real-time, gradient measurement and cancellation protocol. By taking differences of the magnetometry measurements from complementary beams (i.e., between *k*ₙ and *k*'ₙ for n = {1,2,3} of Fig. 4A), even large field gradients across the vapor cell can be rapidly and accurately extracted from the data by AI/ML algorithms in a manner not possible with a simple model fitting approach.

Furthermore, the present approach can be used to actively cancel field gradients by driving calculated currents through a set of custom biplanar coils that create three homogeneous magnetic fields and five independently steerable magnetic gradients (e.g., similar to the planar coils routinely used in magnetic resonance imaging (MRI) systems). In the present magnetometer system, two bi-planar coil slabs can be cemented above and below the vapor cell, forming a rigid structure robust to vibrations and ensuring that gradients are accurately cancelled even on dynamic platforms. The outcome is that all gradients are actively and automatically flattened to levels that permit v-EIT to work in 10 mT/m gradients at its highest sensitivity.

### AI/ML for Robust Extraction of Magnetic Fields from EIT Spectra

An artificial intelligence / machine learning (AI/ML) algorithm can be used to extract vector information from measurements of multiple EIT resonances. Principal component analysis can be used to extract features that represent different presentations of EIT spectra expected to arise in noisy sensing scenarios. With high quality training data, the AI/ML algorithm can be trained to confidently reconstruct φ, θ, and |B| in real-world sensing situations. This method requires observation of the full EIT spectrum, which can be provided in the present magnetometer system.

Further details regarding use of AI/ML algorithms in vector magnetometry can be found in McKelvy et al., Application of kernel principal component analysis for optical vector atomic magnetometry, Mach. Learn.: Sci. Technol., vol. 4, no. 4, p. 045048, Dec. 2023, the disclosure of which is incorporated by reference herein.

### Example of Magnetometer System Architecture

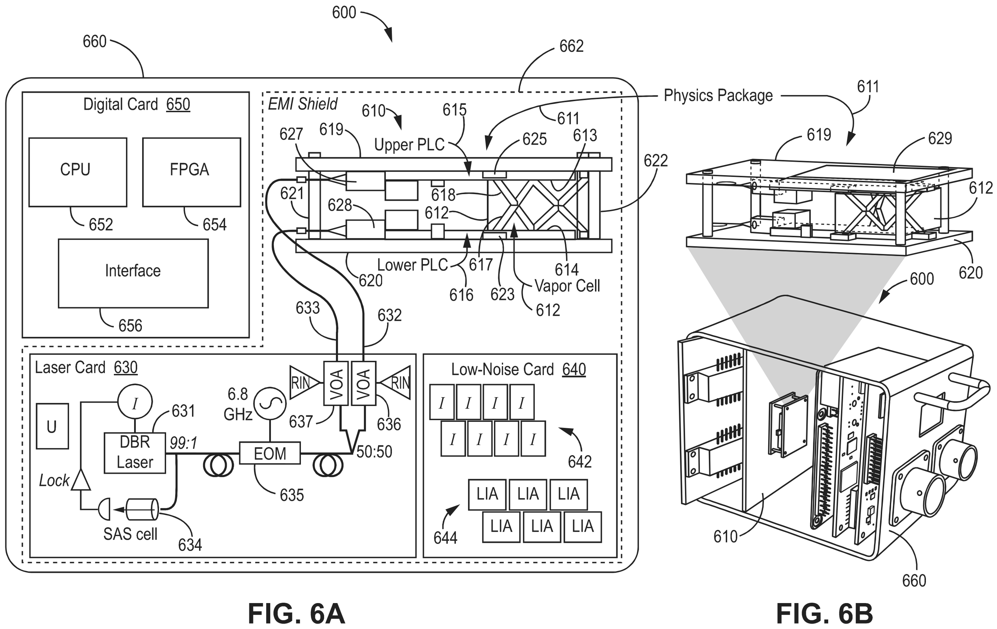

Figures 6A and 6B illustrate an atomic EIT magnetometer system 600 according to another embodiment. The magnetometer system 600 is implemented with a set of functional cards, including a physics package card 610, a laser card 630, a low-noise card 640, and a digital card 650, which are housed in a chassis 660. The physics package card 610, the laser card 630, and the low-noise card 640 are contained in an inner electromagnetic interference (EMI) shield 662 within the chassis 660 to protect these functional cards from environmental radiation and chatter from the digital card 650.

The physics package card 610 houses a physics package 611 that includes a vapor cell 612 with an upper side 613 and a lower side 614. An upper PLC photonic chip 615 is bonded to the upper side 613, and a lower PLC photonic chip 616 is bonded to the lower side 614. The upper PLC photonic chip 615 is configured to direct a first set of laser beams 617 through the vapor cell 612, and the lower PLC photonic chip 616 is configured to direct a second set of laser beams 618 through the vapor cell 612. The upper PLC photonic chip 615 is attached to an upper PCB 619, and the lower PLC photonic chip 616 is attached to a lower PCB 620. The upper PCB 619 and the lower PCB 620 are coupled together and separated from each other by a set of posts 621, 622.

A first set of photodiodes 623 are attached to the lower PCB 620, and are configured to respectively receive the first set of laser beams 617 that pass through the vapor cell 612. A second set of photodiodes 625 are attached to the upper PCB 619, and are configured to respectively receive the second set of laser beams 618 that pass through the vapor cell 612. As shown in Figure 6B, a set of biplanar gradient cancelling coils 629 can be disposed above (and below) the vapor cell 612.

The laser card 630 includes a laser device 631 configured to emit a laser beam, which is split into first and second beam emission portions that are respectively directed to the upper and lower PLC photonic chips 615, 616 through respective optical fibers 632, 633. The optical fibers 632, 633 are respectively edge coupled to the upper and lower PLC photonic chips 615, 616 through respective fiber-to-edge couplers 627, 628.

As shown in Figure 6A, the laser card 630 can provide a compact laser system with polarization control. The laser device 631 can be a distributed Bragg reflector (DBR) laser, such as a commercial off-the-shelf (COTS) fiber-pigtailed single-frequency diode laser, which can be wavelength stabilized via saturated absorption spectroscopy (SAS) with a magnetically shielded miniature reference cell 634. A fiber-pigtailed electro-optic modulator (EOM) 635 can be used to apply phase modulation (PM) sidebands (e.g., at about 6.8 GHz) for EIT spectroscopy. A first variable optical attenuator (VOA) 636 is configured to receive the first beam emission portion and direct it to the optical fiber 632. A second VOA 637 is configured to receive the second beam emission portion and direct it to the optical fiber 633. An in-fiber polarizer can be used just before the launch of the beams into the PLC waveguides to enforce a known polarization and translate any polarization fluctuations into intensity fluctuations that are detected and rejected by a relative intensity noise (RIN) servo. Since one laser feeds all six probe beams, any remaining laser instability is common-mode.

The low-noise card 640 houses a set of current supplies 642 for the biplanar gradient cancelling coils 629, as well as a set of photodiode lock-in amplifiers (LIAs) 644. The digital card 650 houses a central processing unit (CPU) 652, a FPGA 654, and a communication interface 656. The digital card 650 can be configured to host one or more AI/ML algorithms.

The chassis 660 can be a robust, portable chassis such as a VPX-style chassis, as shown in Figure 6B with the functional cards installed including the physics package card 610 with the physics package 611. The magnetometer system 600 provides for ultra-sensitive magnetic sensing that can operate in high magnetic fields, including harsh EMI conditions on aircraft such as helicopters, reaching about 100 ft/rtHz in noise sensitivity.

### Optimized MEMS-Scale Alkali Vapor Cell

The sensitivity of EIT spectroscopy is improved by narrow spectral resonances and high SNR for detecting probe beam absorption. In the present approach, these features flow down to the vapor cell design and construction in several ways. First, larger vapor cells allow longer interaction paths for probe beams, leading to increased SNR; also, larger vapor cells permit atoms to spend more time away from cell walls, reducing the deleterious impact of spin destroying collisions. On the other hand, larger vapor cells push up the overall size, weight, and power (SWaP) of the sensor, and also make the system more sensitive to gradients. Second, the vapor cells needs to contain a buffer gas of optimal composition (e.g., N₂ + Ne) and pressure consistent with operation temperatures for which the alkali vapor density is high.

The present magnetometer system can employ a vapor cell using a chemical pre-cursor based filling method, and an anodic bonding based sealing method. Note that anodically bonded vapor cells are mechanically robust, withstand temperatures as high as 230 °C or higher, and show stable spectroscopy signals for months to years. Furthermore, and unlike spectroscopy cells sealed with epoxy, anodically bonded vapor cells are not attacked by alkali vapor, providing for longer operational lifetimes.

In one example, a rubidium alkali vapor cell can be employed, which is about 5 mm on a side (or larger), in the physics package of the present magnetometer system.

### Immunity to Magnetic Fields and Magnetic Gradients

The EIT magnetometry is not required to operate in only low fields to achieve its ultimate sensitivity limits. It is expected that no degradation of sensitivity for fields as large as 1 mT will occur. In fact, the lower limit on the magnetic field at which degraded sensitivity is anticipated is about 300 mT, where the Zeeman shift becomes comparable to where the 800 MHz excited state hyper-fine splitting and deleterious mixing between excited state hyperfine levels Fₑ = 1 and Fₑ = 2 starts to occur.

The principal impact of magnetic gradients on EIT spectroscopy is inhomogeneous broadening of the resonance lines, which degrades the sensitivity in proportion to the gradient. A dual-triad differencing algorithm can be used to actively detect and flatten gradients during operation, to ensure best sensitivity under any external gradients generated by the platform.

In addition, it can be estimated under what conditions the present EIT magnetometer can operate without any active cancellation and still exceed the state of the art for atomic magnetometry. The EIT magnetometer operating at a photon shot noise (PSN) limited sensitivity of $10 fT / \sqrt{Hz}$ would still have sensitivity of $100 fT / \sqrt{Hz}$ in uncancelled gradients as large as 0.5 mT/m (which broadens the EIT resonance to about 10 kHz); and would reach a respectable $3 pT / \sqrt{Hz}$ (which is substantially better than other optically pumped magnetometers) in uncancelled gradients as large as 10 mT/m.

The processing units and/or other computational devices used in the systems and methods described herein may be implemented using software, firmware, hardware, or appropriate combinations thereof. The processing unit and/or other computational devices may be supplemented by, or incorporated in, specially-designed application-specific integrated circuits (ASICs) or field programmable gate arrays (FPGAs). In some implementations, the processing unit and/or other computational devices may communicate through an additional transceiver with other computing devices outside of the navigation system, such as those associated with a management system or computing devices associated with other subsystems controlled by the management system. The processing unit and/or other computational devices can also include or function with software programs, firmware, or other computer readable instructions for carrying out various process tasks, calculations, and control functions used in the methods and systems described herein.

The methods described herein may be implemented by computer executable instructions, such as program modules or components, which are executed by at least one processor or processing unit. Generally, program modules include routines, programs, objects, data components, data structures, algorithms, and the like, which perform particular tasks or implement particular abstract data types.

Instructions for carrying out the various process tasks, calculations, and generation of other data used in the operation of the methods described herein can be implemented in software, firmware, or other computer readable instructions. These instructions are typically stored on appropriate computer program products that include non-transitory computer readable media used for storage of computer readable instructions or data structures. Such computer readable media may be any available media that can be accessed by a general purpose or special purpose computer or processor, or any programmable logic device.

Suitable computer readable storage media may include, for example, nonvolatile memory devices including semi-conductor memory devices such as Random Access Memory (RAM), Read Only Memory (ROM), Electrically Erasable Programmable ROM (EEPROM), or flash memory devices; magnetic disks such as internal hard disks or removable disks; optical storage devices such as compact discs (CDs), digital versatile discs (DVDs), Blu-ray discs; or any other media that can be used to carry or store desired program code in the form of computer executable instructions or data structures.

### Example Embodiments

Example 1 includes an atomic magnetometer system, comprising: a physics package comprising: a vapor cell having a first side and an opposing second side; a first planar lightwave circuit (PLC) photonic chip coupled to the first side of the vapor cell, the first PLC photonic chip configured to project a first triad of laser beams through the vapor cell; a second PLC photonic chip coupled to the second side of the vapor cell, the second PLC photonic chip configured to project a second triad of laser beams through the vapor cell; a first set of photodetectors configured to receive the first triad of laser beams that pass through the vapor cell; and a second set of photodetectors configured to receive the second triad of laser beams that pass through the vapor cell; at least one laser source in optical communication with the first and second PLC photonic chips, the at least one laser source including a laser device configured to emit a laser beam, which is split into a first beam emission portion that is directed to the first PLC photonic chip, and a second beam emission portion that is directed to the second PLC photonic chip; and at least one processor in operative communication with the physics package and the at least one laser source; wherein the first triad of laser beams projected by the first PLC photonic chip is produced from the first beam emission portion, and the second triad of laser beams projected by the second PLC photonic chip is produced from the second beam emission portion; wherein the at least one processor is configured to perform electromagnetically induced transparency (EIT) magnetometry based on output signals from the first and second sets of photodetectors.

Example 2 includes the atomic magnetometer system of Example 1, further comprising biplanar gradient cancelling coils disposed above and below the vapor cell.

Example 3 includes the atomic magnetometer system of any of Examples 1-2, wherein the at least one laser source is in optical communication with the first and second PLC photonic chips through respective first and second optical fibers.

Example 4 includes the atomic magnetometer system of Example 3, wherein the first and second optical fibers are respectively edge coupled to the first and second PLC photonic chips through respective first and second fiber-to-edge couplers.

Example 5 includes the atomic magnetometer system of any of Examples 1-4, wherein the first PLC photonic chip is attached to a first printed circuit board (PCB), and the second PLC photonic chip is attached to a second PCB.

Example 6 includes the atomic magnetometer system of Example 5, wherein the first set of photodetectors are attached to the second PCB, and the second set of photodetectors are attached to the first PCB.

Example 7 includes the atomic magnetometer system of any of Examples 5-6, wherein the first PCB and the second PCB are coupled together and separated from each other by a set of posts.

Example 8 includes the atomic magnetometer system of any of Examples 1-7, wherein the physics package, the at least one laser source, and the at least one processor are implemented with functional cards that are housed in a robust, portable chassis.

Example 9 includes the atomic magnetometer system of any of Examples 1-8, wherein the first and second PLC photonic chips respectively include routing waveguide arrangements, and grating emitters in optical communication with the routing waveguide arrangements.

Example 10 includes the atomic magnetometer system of Example 9, wherein the routing waveguide arrangements direct the beam emission portions to the grating emitters, which are configured to produce the first and second triad of laser beams from the beam emission portions.

Example 11 includes an atomic magnetometer system, comprising: a physics package comprising: a vapor cell having an upper side and a lower side; an upper planar lightwave circuit (PLC) photonic chip coupled to the upper side of the vapor cell, the upper PLC photonic chip configured to direct a first set of laser beams that pass through the vapor cell; a lower PLC photonic chip coupled to the lower side of the vapor cell, the lower PLC photonic chip configured to direct a second set of laser beams that pass through the vapor cell; a first set of photodiodes configured to respectively receive the first set of laser beams that pass through the vapor cell; and a second set of photodiodes configured to respectively receive the second set of laser beams that pass through the vapor cell; wherein the upper PLC photonic chip is attached to an upper printed circuit board (PCB), the lower PLC photonic chip is attached to a lower PCB, the first set of photodiodes are attached to the lower PCB, and the second set of photodiodes are attached to the upper PCB; a laser device configured to emit a laser beam, which is split into a first beam emission portion directed to the upper PLC photonic chip, and a second beam emission portion directed to the lower PLC photonic chip, through respective first and second optical fibers; and at least one processor in operative communication with the physics package and the laser device; wherein the first set of laser beams that pass through the vapor cell is produced from the first beam emission portion, and the second set of laser beams that pass through the vapor cell is produced from the second beam emission portion; wherein the at least one processor is configured to perform electromagnetically induced transparency (EIT) magnetometry based on output signals from the first and second sets of photodiodes.

Example 12 includes the atomic magnetometer system of Example 11, further comprising biplanar gradient cancelling coils disposed above and below the vapor cell.

Example 13 includes the atomic magnetometer system of Example 12, further comprising: a physics package card coupled with the physics package; a laser card coupled with the laser device; and a digital card coupled with the at least one processor.

Example 14 includes the atomic magnetometer system of Example 13, further comprising a low-noise card that includes a set of current supplies for the biplanar gradient cancelling coils, and a set of photodiode lock-in amplifiers.

Example 15 includes the atomic magnetometer system of Example 14, wherein the physics package card, the laser card, and the low-noise card are contained in an electromagnetic interference (EMI) shield within a chassis to provide protection from environmental radiation and chatter from the digital card.

Example 16 includes the atomic magnetometer system of any of Examples 13-15, wherein the digital card is coupled with a central processing unit (CPU), a field programmable gate array (FPGA), and a communication interface.

Example 17 includes the atomic magnetometer system of any of Examples 13-16, wherein the digital card is configured to host one or more artificial intelligence or machine learning algorithms that are operative to process EIT spectra data collected simultaneously from the first and second sets of laser beams probing the vapor cell.

Example 18 includes the atomic magnetometer system of any of Examples 11-17, wherein the laser device comprises a distributed Bragg reflector (DBR) laser.

Example 19 includes the atomic magnetometer system of any of Examples 11-18, wherein the laser device comprises a fiber-pigtailed single-frequency diode laser, which is wavelength stabilized via saturated absorption spectroscopy (SAS) with a magnetically shielded miniature reference cell.

Example 20 includes the atomic magnetometer system of Example 19, wherein the laser device further comprises: a fiber-pigtailed electro-optic modulator (EOM) that applies phase modulation sidebands for EIT spectroscopy; a first variable optical attenuator configured to receive the first beam emission portion and direct the first beam emission portion to the first optical fiber; and a second variable optical attenuator configured to receive the second beam emission portion and direct the second beam emission portion to the second optical fiber.

The present invention may be embodied in other specific forms without departing from its essential characteristics. The described embodiments are to be considered in all respects only as illustrative and not restrictive. The scope of the invention is therefore indicated by the appended claims rather than by the foregoing description. All changes that come within the meaning and range of equivalency of the claims are to be embraced within their scope.

## Claims

1. An atomic magnetometer system, comprising:
a physics package comprising:
a vapor cell having a first side and an opposing second side;
a first planar lightwave circuit (PLC) photonic chip coupled to the first side of the vapor cell, the first PLC photonic chip configured to project a first triad of laser beams through the vapor cell;
a second PLC photonic chip coupled to the second side of the vapor cell, the second PLC photonic chip configured to project a second triad of laser beams through the vapor cell;
a first set of photodetectors configured to receive the first triad of laser beams that pass through the vapor cell; and
a second set of photodetectors configured to receive the second triad of laser beams that pass through the vapor cell;
at least one laser source in optical communication with the first and second PLC photonic chips, the at least one laser source including a laser device configured to emit a laser beam, which is split into a first beam emission portion that is directed to the first PLC photonic chip, and a second beam emission portion that is directed to the second PLC photonic chip; and
at least one processor in operative communication with the physics package and the at least one laser source;
wherein the first triad of laser beams projected by the first PLC photonic chip is produced from the first beam emission portion, and the second triad of laser beams projected by the second PLC photonic chip is produced from the second beam emission portion;
wherein the at least one processor is configured to perform electromagnetically induced transparency (EIT) magnetometry based on output signals from the first and second sets of photodetectors.

2. The atomic magnetometer system of claim 1, further comprising biplanar gradient cancelling coils disposed above and below the vapor cell.

3. The atomic magnetometer system of claim 1, wherein the at least one laser source is in optical communication with the first and second PLC photonic chips through respective first and second optical fibers.

4. The atomic magnetometer system of claim 1, wherein:
the first PLC photonic chip is attached to a first printed circuit board (PCB), and the second PLC photonic chip is attached to a second PCB; and
the first set of photodetectors are attached to the second PCB, and the second set of photodetectors are attached to the first PCB.

5. The atomic magnetometer system of claim 1, wherein the physics package, the at least one laser source, and the at least one processor are implemented with functional cards that are housed in a robust, portable chassis.

6. The atomic magnetometer system of claim 1, wherein:
the first and second PLC photonic chips respectively include routing waveguide arrangements, and grating emitters in optical communication with the routing waveguide arrangements; and
the routing waveguide arrangements direct the beam emission portions to the grating emitters, which are configured to produce the first and second triad of laser beams from the beam emission portions.

7. An atomic magnetometer system, comprising:
a physics package comprising:
a vapor cell having an upper side and a lower side;
an upper planar lightwave circuit (PLC) photonic chip coupled to the upper side of the vapor cell, the upper PLC photonic chip configured to direct a first set of laser beams that pass through the vapor cell;
a lower PLC photonic chip coupled to the lower side of the vapor cell, the lower PLC photonic chip configured to direct a second set of laser beams that pass through the vapor cell;
a first set of photodiodes configured to respectively receive the first set of laser beams that pass through the vapor cell; and
a second set of photodiodes configured to respectively receive the second set of laser beams that pass through the vapor cell;
wherein the upper PLC photonic chip is attached to an upper printed circuit board (PCB), the lower PLC photonic chip is attached to a lower PCB, the first set of photodiodes are attached to the lower PCB, and the second set of photodiodes are attached to the upper PCB;
a laser device configured to emit a laser beam, which is split into a first beam emission portion directed to the upper PLC photonic chip, and a second beam emission portion directed to the lower PLC photonic chip, through respective first and second optical fibers; and
at least one processor in operative communication with the physics package and the laser device;
wherein the first set of laser beams that pass through the vapor cell is produced from the first beam emission portion, and the second set of laser beams that pass through the vapor cell is produced from the second beam emission portion;
wherein the at least one processor is configured to perform electromagnetically induced transparency (EIT) magnetometry based on output signals from the first and second sets of photodiodes.

8. The atomic magnetometer system of claim 7, further comprising biplanar gradient cancelling coils disposed above and below the vapor cell.

9. The atomic magnetometer system of claim 8, further comprising:
a physics package card coupled with the physics package;
a laser card coupled with the laser device;
a digital card coupled with the at least one processor; and
a low-noise card that includes a set of current supplies for the biplanar gradient cancelling coils, and a set of photodiode lock-in amplifiers.

10. The atomic magnetometer system of claim 9, wherein the digital card is configured to host one or more artificial intelligence or machine learning algorithms that are operative to process EIT spectra data collected simultaneously from the first and second sets of laser beams probing the vapor cell.
